(19) Europäisches Patentamt
European Patent Office
Office européen des brevets

(11) **EP 1 384 269 B1**

## (12) EUROPÄISCHE PATENTSCHRIFT

(45) Veröffentlichungstag und Bekanntmachung des Hinweises auf die Patenterteilung:
**26.12.2012 Patentblatt 2012/52**

(21) Anmeldenummer: 02737772.0

(22) Anmeldetag: **03.04.2002**

(51) Int Cl.:
*H01L 29/745* (2006.01)   *H01L 29/749* (2006.01)
*H01L 29/06* (2006.01)   *H01L 29/10* (2006.01)
*H01L 21/332* (2006.01)

(86) Internationale Anmeldenummer:
**PCT/DE2002/001196**

(87) Internationale Veröffentlichungsnummer:
**WO 2002/084743 (24.10.2002 Gazette 2002/43)**

(54) **MIS-HALBLEITERLEISTUNGSBAUELEMENT UND ENTSPRECHENDES HERSTELLUNGSVERFAHREN**

METAL INSULATOR POWER SEMICONDUCTOR COMPONENT (MIS) AND A METHOD FOR PRODUCING THE SAME

ELEMENT SEMI-CONDUCTEUR DE PUISSANCE MIS ET PROCEDE DE FABRICATION ASSOCIE

(84) Benannte Vertragsstaaten:
**DE GB IT**

(30) Priorität: **10.04.2001 DE 10117802**

(43) Veröffentlichungstag der Anmeldung:
**28.01.2004 Patentblatt 2004/05**

(73) Patentinhaber: **ROBERT BOSCH GMBH**
**70442 Stuttgart (DE)**

(72) Erfinder:
• **PLIKAT, Robert**
**29369 Ummern (DE)**
• **FEILER, Wolfgang**
**72766 Reutlingen (DE)**

(56) Entgegenhaltungen:
**DE-A- 19 604 043   DE-A- 19 736 981**
**DE-C- 19 840 032   US-A- 5 216 275**

• **SHEKAR M S ET AL: "Experimental demonstration of the emitter switched thyristor" , POWER SEMICONDUCTOR DEVICES AND ICS, 1991. ISPSD '91., PROCEEDINGS OF THE 3RD INTERNATIONAL SYMPOSIUM ON BALTIMORE, MD, USA 22-24 APRIL 1991, NEW YORK, NY, USA, IEEE, US, PAGE(S) 128-131 XP010044326 ISBN: 0-7803-0009-2 Abbildung 1**
• **IWAMURO N ET AL: "A study of EST's short-circuit SOA" , POWER SEMICONDUCTOR DEVICES AND ICS, 1993. ISPSD '93., PROCEEDINGS OF THE 5TH INTERNATIONAL SYMPOSIUM ON MONTEREY, CA, USA 18-20 MAY 1993, NEW YORK, NY, USA,IEEE, US, PAGE(S) 71-76 XP010116915 ISBN: 0-7803-1313-5 Abbildung 1**

EP 1 384 269 B1

**Beschreibung**

STAND DER TECHNIK

Die vorliegende Erfindung betrifft ein Halbleiterleistungsbauelement und ein entsprechendes Herstellungsverfahren.

Obwohl auch auf andere ähnliche Halbleiterleistungselemente anwendbar, werden die vorliegende Erfindung sowie die ihr zugrundeliegende Problematik in bezug auf einen EST(Emitter Switched Thyristor) erläutert.

Allgemein werden die ESTs als Leistungsschalter im Bereich von einigen hundert bis einigen tausend Volt Sperrspannung eingesetzt. Insbesondere ist der Einsatz von solchen ESTs als Zündtransistor, d.h. als Schalter auf der Primärseite einer Zündspule, von besonderem Interesse.

Allgemein ergibt sich die. Struktur des ESTs aus derjenigen des bekannten V-IGBTs (Vertikal Insulated Gate Bipolar Transistor) durch Hinzufügen zusätzlicher, mittels Diffusionsgebieten abgeschirmter, floatender Emitterstrukturen an der Chipoberseite. Der Vorteil von ESTs gegenüber V-IGBTs wird allgemein in einem besseren Durchlassverhalten gesehen, d.h. einem geringeren Spannungsabfall im eingeschalteten Zustand. Wie beim V-IGBT wird der Anschluss, der mit dem rückseitigen Emitter verbunden ist, als Anode bezeichnet, der Steueranschluss als Gate und der Anschluss an die Source- und Body-Diffusionen als Kathode.

Wie aus B.J. Baliga, Power Semiconductor Devices, PWS Publishing Company, Boston 1995, S. 543-568 bekannt, gibt es hinsichtlich der Gestaltung der MOS-Steuerköpfe im wesentlichen zwei Typen des EST, deren aktives Gebiet aus einer Vielzahl parallelgeschalteter streifen- oder zellförmiger MOS-Steuerköpfe und floatender Emitterstrukturen besteht.

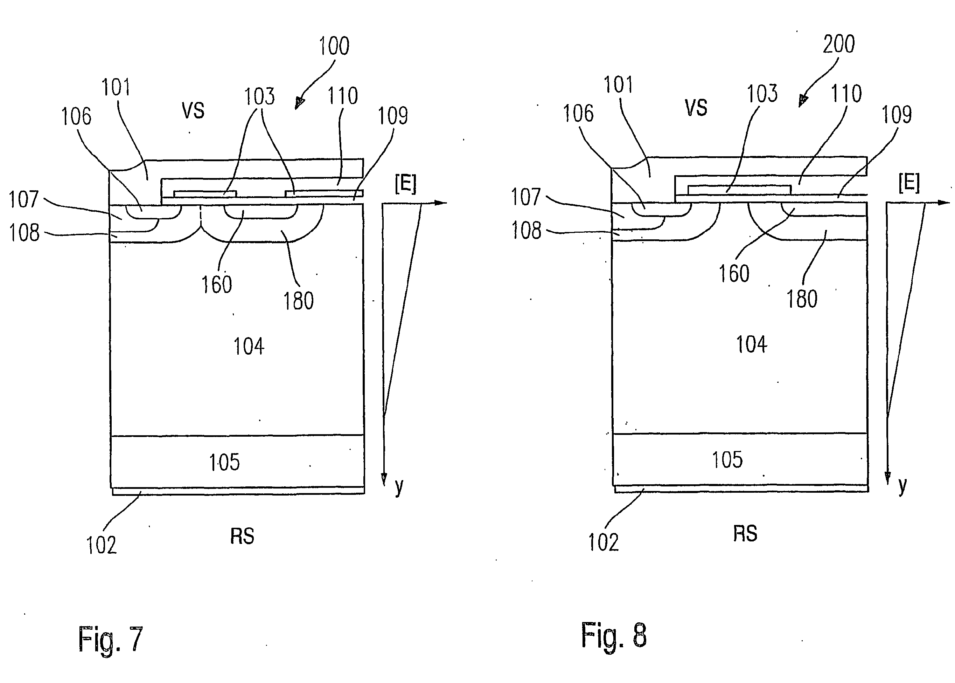

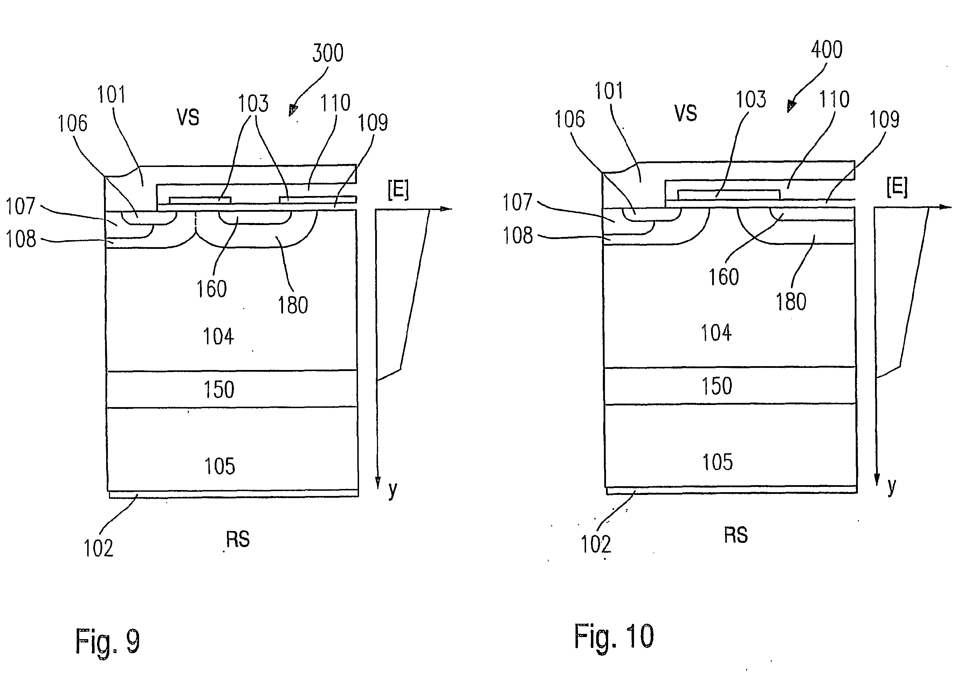

Der erste Typ ist der sogenannte Single-Channel-EST (SC-EST), dessen Halbzellen-Ouerschnitt 100 in Fig. 7 bzw. 9 gezeigt ist. Der zweite Typ ist der sogenannte Dual-Channel-EST (DC-EST), dessen Halbzellen-Querschnitt 200 in Fig. 8 bzw. 10 gezeigt ist.

Wie beim V-IGBT gibt es hinsichtlich der Gestaltung des Emitters auf der Chiprückseite im wesentlichen zwei Typen, den Punch-Through-Typ (PT-Typ), dessen Halbzellen-Querschnitt 300 in Fig. 9 bzw. 10 gezeigt ist, und den Non-Punch-Through-Typ, dessen Halbzellen-Querschnitt 400 in Fig. 7 bzw. 8 gezeigt ist.

Aus der Kombination dieser genannten Gestaltungsmöglichkeiten gibt es also die folgenden vier Grundtypen des vertikalen ESTs: den SC-NPT-EST (Fig. 7), den SC-PT-EST (Fig. 9), den DC-NPT-EST (Fig. 8) und den DC-PT-EST (Fig. 10).

Eine genauere Beschreibung der Funktionsweise von diesen ESTs wird nachfolgend anhand von Fig. 7 bis Fig. 10 gegeben, wobei gleiche Teile bzw. Teile gleicher Funktionalität mit gleichen Bezugszeichen versehen sind.

Die Funktionsweise im Durchlassfall ist für den SC-NPT-EST 100 gemäß Fig. 7 folgendermaßen.

Bei diesem SC-NPT-EST setzt sich das üblicherweise aus Polysilizium bestehende Gate 103 pro Halbzelle aus zwei Teilen zusammen, die über die dritte, nicht gezeichnete Dimension miteinander verbunden sind. Das nur mittels einer dünnen Gateoxidschicht 109 vom Halbleiter isolierte Gate wird gegenüber der Kathode 101, deren Metallisierung sich auf einem Bezugspotential befindet, auf ein Potential oberhalb der Schwellspannung der MOS-Steuerköpfe 106, 107, 108, 160, 180 gebracht. Die Zwischenoxidschicht 110 dient der Isolation der Kathode 101 vom Gate 103.

Daraufhin werden im Bereich der p-Gebiete (p-Bodygebiet 108, p-Gebiet 180) Inversionskanäle an der HL-Oberfläche unter dem Gate 103 erzeugt und die Halbleiteroberfläche im Bereich des $n^-$-dotieren Driftgebiets 104 in Akkumulation gebracht. Bei einer gegenüber der Kathode 101 positiven Anodenspannung an der chiprückseitigen Metallisierung der Anode 102 werden Elektronen über die $n^+$-Gebiete 106, 160, die influenzierten MOS-Kanäle und die Akkumulationsschicht in das $n^-$-Driftgebiet 104 injiziert. Daraufhin injiziert der anodenseitige $p^+$-dotierte Emitter 105 Löcher in das $n^-$-Driftgebiet 104, die über die p-Gebiete 180, 108 und das $p^+$-Kontaktgebiet 107 zur Kathode 101 abfließen.

Ab einer bestimmten Stromdichte wird infolge des durch den Löcherstromanteil im p-Gebiet 180 hervorgerufenen lateralen Spannungsabfalls der pn-Übergang zwischen dem $n^+$-Gebiet 160 und dem p-Gebiet 180 in Flussrichtung gepolt, wodurch vom jetzt als Emitter wirkenden $n^+$-Gebiet 160 Elektronen quer über das p-Gebiet 180 ins Driftgebiet 104 injiziert werden, ohne zuvor den unter dem rechten Gateteil gelegenen MOS-Kanal passieren zu müssen.

Die nun aktive, aus dem $n^+$-Gebiet 160, dem p-Gebiet 180, dem $n^-$-Driftgebiet 104 und dem rückseitigen $p^+$-Emitter 105 bestehende Vierschichtstruktur wirkt als Thyristor, dessen $n^+$-Emitter 160 über das $n^+$-Gebiet 106 und den unter dem linken Teil des Gates 103 ausgebildeten MOS-Kanal mit Elektronen versorgt wird und somit mittels dem Gate 103 geschaltet bzw. gesteuert werden kann.

Gegenüber einem normalen Thyristor besitzt der EST demnach den Vorteil, dass er durch ein Absenken der Gate-Kathodenspannung unter die Schwellspannung abgeschaltet werden kann und der durch ihn fließende Strom über die Gatespannung steuerbar ist. Seine Durchlasskennlinie zeigt somit einen Stromsättigungsbereich.

Im Durchlassbetrieb wird das $n^-$-Driftgebiet 104 derart von Ladungsträger überschwemmt, dass seine Leitfähigkeit erhöht wird. Es befindet sich bei üblichen Durchlassstromdichten in Hochinjektion. Die Zwischenoxidschicht 110 dient der Isolation der Kathode 101 vom Gate 103.

Die Funktionsweise im Durchlassfall für den SC-PT-EST 300 gemäß Fig. 9 ist völlig analog zum SC-NPT-EST. Beim SC-PT-EST ist eine zusätzliche n-Bufferschicht 150 vorhanden, deren Funktion im Zusammenhang mit dem Sperrfall erläutert wird. Durch die n-Bufferschicht 150 ist es möglich, die Dicke des n⁻-Driftgebiets 104 zu reduzieren, um eine besseren Durchlasscharakteristik zu erzielen. Der SC-PT-EST lässt sich beispielsweise auf einem p⁺-Substrat mit dem rückseitigen Emitter 105 herstellen, wobei die n-Bufferschicht 150 und das n⁻-Driftgebiet 104 epitaktisch auf diesem p⁺-Substrat aufgewachsen wird.

Die Funktionsweise im Durchlassfall für den DC-PT-EST 200 gemäß Fig. 8 ist ähnlich zur derjenigen des SC-PT-EST 300 gemäß Fig. 9.

Beim DC-PT-EST 200 hat das üblicherweise aus Polysilizium bestehende Gate 103 pro Halbzelle nur einen Teil. Das nur mittels der dünnen Gateoxidschicht 109 von der Halbleiteroberfläche isolierte Gate 103 wird gegenüber der Kathode 101, deren Metallisierung sich auf einem Bezugspotential befindet, auf ein Potential oberhalb der Schwellspannung der MOS-Steuerköpfe 106, 107, 108, 160, 180 gebracht. Daraufhin werden im Bereich der p-Gebiete (p-Bodygebiet 108, p-Gebiet 180) Inversionskanäle an der Halbleiteroberfläche unter dem Gate 103 erzeugt und die Halbleiteroberfläche im Bereich des n⁻-dotierten Driftgebiets 104 in Akkumulation gebracht. Bei einer gegenüber der Kathode 101 positiven Anodenspannung an der chiprückseitigen Metallisierung der Anode 102 werden Elektronen über das n⁺-Gebiet 106, den linken influenzierten MOS-Kanal und die Akkumulationsschicht in das n⁻-Driftgebiet 104 injiziert. Daraufhin injiziert der anodenseitige p⁺-dotierte Emitter 105 Löcher in das n⁻-Driftgebiet 104, die einerseits über das p⁺-Kontaktgebiet 107 und das p-Bodygebiet 108, andererseits über das p⁺-Kontaktgebiet 107 und über die p-Gebiete 180, 108 und den zwischen ihnen liegenden Teil des Driftgebiets 104 zur Kathode 101 abfließen. Ab einer bestimmten Stromdichte wird infolge des durch den Löcherstromanteil im p-Gebiet 180 und dem lateral angrenzenden Teil des n⁻-Driftgebiets 104 hervorgerufenen lateralen Spannungsabfalls der pn-Übergang zwischen dem n⁺-Gebiet 160 und dem p-Gebiet 180 in Flussrichtung gepolt, wodurch vom jetzt als Emitter wirkenden n⁺-Gebiet 160 Elektronen quer über das p-Gebiet 180 ins n⁻-Driftgebiet 104 injiziert werden, nachdem sie zuvor die unter dem Gate gelegenen MOS-Kanäle und die Akkumulationsschicht passiert haben.

Die nun aktive, aus dem n⁺-Gebiet 160, dem p-Gebiet 180, dem n⁻-Driftgebiet 104 und dem rückseitigen p⁺-Emitter 105 bestehende Vierschichtstruktur wirkt als Thyristor, dessen n⁺-Emitter 160 über das n⁺-Gebiet 106 und den unter dem Gate 103 ausgebildeten Kanal mit Elektronen versorgt wird und somit mittels dem Gate geschaltet bzw. gesteuert werden kann.

Im Durchlassbetrieb wird das n⁻-Driftgebiet 104 derart von Ladungsträgern überschwemmt, dass seine Leitfähigkeit erhöht wird. Es befindet sich bei üblichen Durchlassstromdichten in Hochinjektion.

Gegenüber den weiter oben beschriebenen Single-Channel-ESTs haben Dual-Channel-ESTs den Vorteil eines weiter ausgedehnten sicheren Arbeitsbereichs in Vorwärtsrichtung (FBSOA).

Die Funktionsweise im Durchlassfall für den DC-PT-NPT gemäß Fig. 10 ist völlig analog zum DC-NPT-EST.. Beim DC-PT-EST ist die zusätzliche n-Bufferschicht 150 vorhanden, deren Funktion im Zusammenhang mit dem Sperrfall erläutert wird. Durch die n-Bufferschicht 150 ist es möglich, die Dicke des n⁻-Driftgebiets 104 zu reduzieren, um eine bessere Durchlasscharakteristik zu erzielen. Ein DC-PT-EST lässt sich analog zum SC-PT-EST herstellen.

Im Sperrfall wird beim SC-NPT-EST gemäß Fig. 7 und beim DC-NPT-EST gemäß Fig. 8 das Gate 103 wird gegenüber der Kathode 101 auf eine Spannung unterhalb der Schwellspannung gebracht. Bringt man die Anode 102 nun auf ein positives Potential, dehnt sich die an der Grenze zwischen den p-Gebieten 108, 180 und n⁻-Driftgebiet 104 ausgebildete Raumladungszone fast ausschließlich in das n⁻-Driftgebiet 104 aus. Die Dicke der n⁻-Driftzone 104 ist größer gewählt, als die Weite, die die Raumladungszone bei einer gegebenen maximalen Sperrfähigkeit des Bauelements aufweist, die maßgeblich durch die Driftzonendotierung bestimmt wird. Dies führt zu dem in Fig. 7 bzw. Fig. 8 angedeuteten dreieckförmigen Verlauf der elektrischen Feldstärke |E| entlang der y-Koordinate. Das Maximum der Feldstärke befindet sich dabei im Bereich der MOS-Steuerköpfe 106, 107, 108, 160, 180.

Der Sperrfall für den SC-PT-EST gemäß Fig. 9 und den DC-PT-EST gemäß Fig. 10 läßt sich folgendermaßen beschreiben. Bei diesen PT-ESTs ist die Dicke der n⁻-Driftzone 104 kleiner gewählt, als die Weite, die die Raumladungszone bei einer gegebenen maximalen Sperrfähigkeit des Bauelements aufweisen würde. Um ein Auflaufen der Raumladungszone auf den p⁺-Emitter 105 und einen damit verbundenen Stromfluss zu verhindern, wird hier die n-dotierte Bufferzone 150 mit dem Ziel eingebracht, den Punch-Through zu vermeiden. Dies führt zu dem in Fig. 9 bzw. Fig. 10 angedeuteten trapezförmigen Verlauf der elektrischen Feldstärke |E| entlang der y-Koordinate. Das Maximum der Feldstärke befindet sich auch hier im Bereich der MOS-Steuerköpfe 106, 107, 108, 160, 180. Neben einer Verhinderung des Punch-Throughs ermöglicht die n-Bufferzone 150 außerdem eine Einstellung des Emitterwirkungsgrades und damit des Durchlass- und Schaltverhaltens der PT-ESTs.

Die Tatsache, dass das Feldmaximum im Bereich der MOS-Steuerköpfe 106, 107, 108, 160, 180 liegt, ist für die weiter unten beschriebene Zündapplikation von Nachteil, so dass es die der vorliegenden Erfindung zugrundeliegende Problematik ist, diesen ungünstigen Feldverlauf mittels geeigneter Maßnahmen zu optimieren. Zur Beeinflussung des Feldverlaufs durch Diffusionsgebiete sind im Stand der Technik die nachfolgend genannten Prinzipien bekannt.

In der DE 198 16 448 C1 wird eine Universal-Halbleiterscheibe für Hochspannungsbauelemente, u.a. für V-IGBTs, vorgeschlagen, bei der auf einem z.B. n-dotierten Halbleitersubstrat mindestens eine n-dotierte epitaktische Schicht vorgesehen ist, wobei in den Grenzflächen zwischen dem Substrat und der mindestens einen epitaktischen Schicht eine Vielzahl von floatenden, p-dotierten Halbleitergebieten eingebettet ist, die so bemessen sind, dass die Abmessung eines floatenden Gebiets klein gegenüber der Schichtdicke der mindestens einen epitaktischen Schicht ist und im wesentlichen dem Abstand zwischen den floatenden Gebieten in einer Grenzfläche entspricht oder kleiner als diese ist. Dabei können die in einer Ebene liegenden floatenden Gebiete miteinander verbunden sein, so dass sie ein Gitter bilden. Im Beispiel des V-IGBTs wird davon ausgegangen, dass im aktiven Gebiet des V-IGBTs bei angelegter Sperrspannung die Ladungsträger nicht vollständig aus den floatenden p-Gebieten ausgeräumt werden.

In der DE 198 40 032 C1 wird ein MOS-Transistor (z.B. n-Kanal V-DMOS) mit nicht floatender Kompensationsstruktur im n-Driftgebiet vorgeschlagen. Dieser ist dadurch gekennzeichnet, dass die Kompensationsstruktur und/oder das n-Driftgebiet derart dotiert sind, dass sich der Kompensationsgrad in die Tiefe des Bauelements hin monoton (kontinuierlich oder stufenförmig) folgendermaßen verändert. Bei Durchlaufen der Kompensationsstruktur von Source nach Drain überwiegt sourceseitig die p-Dotierungsdosis die n-Dotierungsdosis, während am drainseitigen Ende der Kompensationsstruktur die n-Dotierungsdosis die p-Dotierungsdosis überwiegt. Unter Sperrspannung stellt sich eine buckelförmige Feldverteilung ein, die ihr Maximum etwa in de Mitte der Vertikalausdehnung der Kompensationssstruktur hat, wo sich n- und p-Dotierungsdosis gerade kompensieren. Zwischen dem drainseitigen Ende der Kompensationsstruktur und dem $n^+$-Substrat kann optional eine niedrigdotierte n-Schicht angeordnet werden. Zweck ist in jedem Fall eine erhöhte Prozesssicherheit und eine erhöhte Robustheit im Durchbruch.

In der DE 196 04 043 A1 sind Möglichkeiten vorgeschlagen worden, mittels in das Driftgebiet eingelassener n-dotierter und p-dotierter Bereiche die Feldverteilung in einem MOS-Transistor oder V-IGBT günstig zu beeinflussen, um bei einer gegebenen Sperrfähigkeit den Durchlassspannungsabfall zu reduzieren. Dabei ist die Gesamtmenge der Dotierung der eingebrachten n-Bereiche etwa gleich der Gesamtmenge der Dotierung der eingebrachten p-Bereiche. Die eingebrachten Bereiche können dabei statistisch verteilt oder strukturiert kugel-, streifen- oder fadenförmig sein und paarweise eingebracht sein. Ihr Abstand ist größer oder gleich null, jedoch kleiner als die Raumladungszone. Die p-Gebiete sind floatend ausgeführt. Im Fall statistisch verteilter p- und n-Gebiete sollte die durchschnittliche Konzentration der verteilten p-Gebiete gleich groß oder größer der der eingebrachten n-Gebiete sein.

Zur Herstellung wird u.a. ein Verfahren vorgeschlagen, das, beginnend mit einem Rohwafer, mittels einer mehrmaligen Abfolge von Epitaxie, Implantation und Diffusion, die p- und n-dotierten Bereiche im n-Driftgebiet erzeugt.

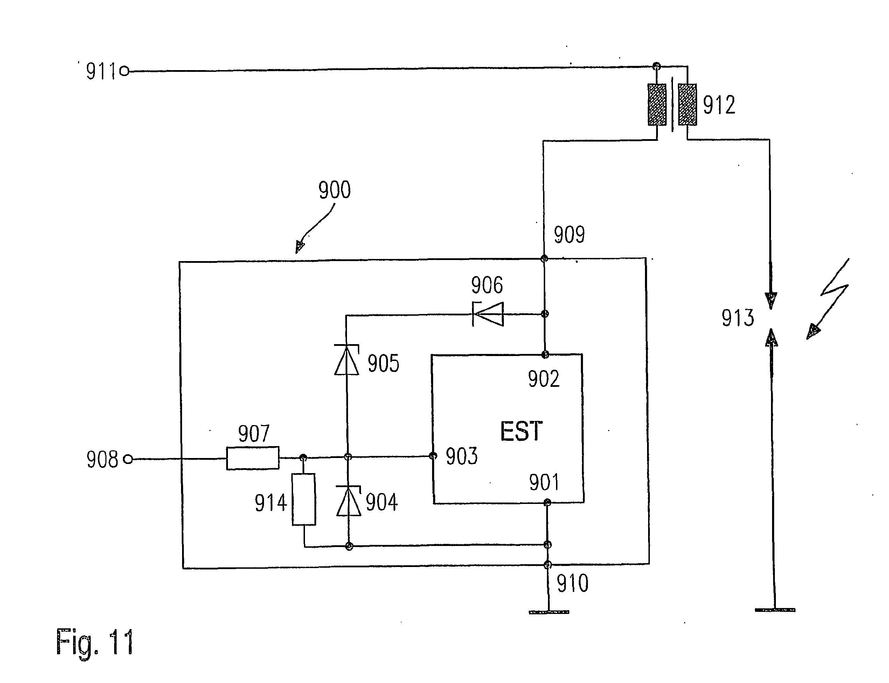

Fig. 11 zeigt eine übliche Schaltungstopologie wie sie für IGBTs in Zündanwendungen verwendet wird und die auch für ESTs geeignet wäre. Würde man einen bekannten EST in einer solchen Topologie als Schaltelement einsetzen, gäbe es Probleme mit der Impulsfestigkeit des Bauelements. Diese Probleme werden nach einer kurzen Erläuterung der Funktionalität der Schaltung näher beschrieben.

In der Zündapplikation wird ein Schaltelement 900 mit einer typischen Sperrfähigkeit von 400-600V und den Anschlüssen Kathode 901, Anode 902 und Gate 903 über eine Zündspule 912 mit der Batteriespannung 911 verbunden. Auf der Sekundärseite der Zündspule 912 ist eine Zündkerze 913 angeschlosse. Die Diode 904 dient dem ESD-Schutz und die optional vorhandene Diode 906 verhindert im Durchlassfall einen Stromfluss vom Gate zur Anode. Die Widerstände 907, 914 mit z.B. R907 = 1kΩ und R914 = 10-25kΩ legen einerseits den Eingangswiderstand der Anordnung fest, bilden andererseits die Last der Klammerdiode 905, die bei der Verwendung von IGBTs als Schaltelement üblicherweise als eine Kette in Sperrichtung gepolter Polysilizium-Zenerdioden ausgeführt ist. Die Elemente 904, 905, 906, 907, 914 sind üblicherweise monolithisch integriert, wobei die Dioden 904, 906 normalerweise aus Polysilizium bestehen.

Die Schaltungsanordnung ist von einem Steuergerät direkt über den Steueranschluss 908 betreibbar. Dazu wird an 908 eine positive Spannung von z.B. 5V gelegt, woraufhin ein leitender Pfad zwischen den Elektroden 901, 902 des Schaltelements geöffnet wird und ein Stromanstieg durch die Zündspule initiiert wird. Zu einem bestimmten Zeitpunkt wird die Spannung am Steueranschluß 908 auf ca. 0V reduziert, woraufhin der leitende Pfad zwischen den Elektroden 901, 902 des Schaltelements verschwindet und die Spannung an den Knoten 902, 909 steil ansteigt. Der Spannungsanstieg wird auf die Sekundärseite der Zündspule 912 hochtransformiert und führt zu einem Zündfunken and er Zündkerze 913. Die Klammerdiode 905 hat die Aufgabe, den Spannungsanstieg an der Anode 902 auf die sogenannte Klammerspannung von ca. 400V zu begrenzen, um einerseits das Schaltelement, andererseits die übrigen Schaltungskomponenten.zu schützen. Dies ist insbesondere im sogenannten Impulsfall von Bedeutung.

Dieser tritt auf, wenn, z.B. infolge eines abgefallenen Zündkabels, kein Zündfunke erzeugt wird. Dann muss das Schaltelement 900 die sonst im Funken umgesetzte Energie aufnehmen. Ohne eine Spannungsbegrenzung würde die Anodenspannung an den Knoten 902, 909 hierbei bis zum Durchbruch des Schaltelements ansteigen und es zerstören. Dies wird mittels der Klammerdiode 905 dadurch verhindert, dass sie bei Erreichen einer vorgewählten Klammerspannung des Schaltelements über den Steueranschluss gerade so stark ansteuern, dass ein Überschreiten der Klammerspannung an 902, 909 vermieden wird. Dennoch stellt dieser Betriebsfall durch die hohe umgesetzte Energie eine hohe Anforderung an die Impulsfestigkeit des Schaltelements dar, die nicht immer in ausreichendem Maße zu gewährleisten ist. Die Folge ist eine Zerstörung des Schaltelements.

Dies würde sich im Fall der Nutzung eines ESTs als Schaltelement wie folgt ereignen. Im Impulsfall hat die Raumladungszone das gesamte n$^-$-Driftgebiet 104 erfasst. Über eine mittels der Klammerdioden 905, 906 kontrollierte Ansteuerung des Gates 103 werden Elektronen über den ausgebildeten MOS-Kanal ins Driftgebiet injiziert, die den p$^+$-Emitter 105 ansteuern. Infolge der hohen Stromdichte, der hohen elektrischen Feldstärke und damit der hohen Verlustleistung im Bereich der MOS-Steuerköpfe wird das Bauelement insbesondere an der Kathode sehr heiß, woraufhin es zu einem Elektronenleckstrom aus den MOS-Steuerköpfen kommt. Die Elektronen laufen in Richtung Anode und steuern den p$^+$-Emitter 105 auf. Sie wirken also wie eine zusätzliche Ansteuerung des ESTs. Um die Spannung auf den Wert der Klammerspannung zu halten, wird über die Klammerdiode 905 die Ansteuerung des Gates 103 entsprechend reduziert.

Unter bestimmten Betriebsbedingungen ist die Aufsteuerung durch den thermisch bedingten Elektronenleckstrom so stark, dass der EST den Laststrom ohne Gateaufsteuerung führen kann (dies wird insbesondere begünstigt, wenn der Emitterwirkungsgrad mit steigender Temperatur zunimmt). Die Steuerbarkeit des ESTs geht verloren, die Temperatur steigt weiter an, der Leckstrom steigt weiter an. Es kommt schließlich zu einer thermischen Mitkopplung, und der EST wird zerstört.

## VORTEILE DER ERFINDUNG

Das erfindungsgemäße Halbleiterleistungsbauelement mit den Merkmalen des Anspruchs 1 bzw. 2 und das entsprechende Herstellungsverfahren nach Anspruch 7 bzw. 8 weisen den Vorteil auf, daß ein robuster EST mit hoher Impulsfestigkeit bereitgestellt wird.

Das erfindungsgemäße Halbleiterleistungsbauelement ist gegenüber den in DE 196 04 043 A1 vorgeschlagenen Strukturen einfacher herstellbar bzw. weist gegenüber den in DE 198 40 032 C1 vorgeschlagenen Strukturen eine erhöhte Impulsfestigkeit auf. Die erfindungsgemäßen Halbleiterleistungsbauelemente lassen insbesondere auch kleine Halbzellweiten in einfacher Weise zu.

Die der vorliegenden Erfindung zugrundeliegende Idee besteht darin, daß in das Driftgebiet des zweiten Leitungstyps eingebrachte, Driftgebiete des ersten Leitungstyps in Streifen- bzw. Säulenform vorgesehen werden, die z.B. über ein Bodygebiet des ersten Leitungstyps mit Kontaktdiffusion des ersten Leitungstyps mit dem Kathodenmetall verbunden sind, so dass ihr Potential nicht floatet. Sie dienen bei der Aufnahme von Sperrspannung zur Ladungskompensation.

Gegenüber den schon bekannten Strukturen aus DE 196 04 043 A1, bei denen zwei unterschiedliche (n- und p-) dotierte Zonentypen einzubringen sind, lassen sich die erfindungsgemäßen Strukturen einfacher herstellen, da in das Driftgebiet stets nur ein weiterer Typ von Driftgebieten eingebracht werden muss.

Des weiteren unterscheiden sich die hier vorgeschlagenen Strukturen dadurch von denen in DE 196 04 043 A1, das die im aktiven Gebiet des ESTs, z.B. pro Halbzelle, eingebrachte gesamte Nettodosis der Driftgebiete des ersten Leitungstyps größer ist, als die Nettodosis des im aktiven Gebiet, zwischen den Driftgebieten des ersten Leitungstyps angeordneten Teils des Driftgebiets des zweiten Leitungstyps.

Die erfindungsgemäßen Strukturen unterscheiden sich von den in DE 198 40 032 C1 vorgeschlagenen dadurch, dass der Kompensationsgrad K(y) nicht monoton von der ersten Halbleiteroberfläche y=0 mit wachsendem y in die Tiefe des Bauelements abnimmt. Vielmehr ist der Kompensationsgrad so einzustellen, dass er im Bereich des von der ersten Halbleiteroberfläche entfernten Endes der Driftgebiete des ersten Leitungstyps ein Maximum aufweist und dass der Driftbereich des ersten Leitungstyps vor Einsetzen des Avalanchedurchbruchs vollständig an Ladungsträgern verarmt.

In den Unteransprüchen finden sich vorteilhafte Weiterbildungen und Verbesserungen des jeweiligen Gegenstandes der Erfindung.

Gemäß einer bevorzugten Weiterbildung ist zwischen dem ersten Driftbereich und dem rückseitigen Emitterbereich ein Buffergebiet des zweiten Leitungstyps vorgesehen.

Gemäß einer weiteren bevorzugten Weiterbildung umschließt ein Kontaktgebiet des ersten Leitungstyps den Sourcebereich teilweise.

Gemäß einer weiteren bevorzugten Weiterbildung verlaufen der erste Bodybereich und der Sourcebereich einerseits und der dritte Driftbereich andererseits streifenförmig verlaufen und nicht parallel zueinander.

Gemäß einer weiteren bevorzugten Weiterbildung umschließt der dritte Driftbereich einen mit einem Isolationsmaterial gefüllten Graben.'

Gemäß einer weiteren bevorzugten Weiterbildung ist der erste Leitungstyp der n-Typ und der zweite Leitungstyp der p-Typ.

## ZEICHNUNGEN

Ausführungsbeispiele der Erfindung sind in den Zeichnungen dargestellt und in der nachfolgenden Beschreibung näher erläutert.

Es zeigen:

| Fig. 1 | eine schematische Querschnittsdarstellung eines Halbleiterleistungsbauelements gemäß einer ersten Ausführungsform der vorliegenden Erfindung; |
| Fig. 2 | eine schematische Querschnittsdarstellung eines Halbleiterleistungsbauelements gemäß einer zweiten Ausführungsform der vorliegenden Erfindung; |
| Fig. 3 | eine schematische Querschnittsdarstellung eines Halbleiterleistungsbauelements gemäß einer dritten Ausführungsform der vorliegenden Erfindung; |
| Fig. 4 | eine schematische Querschnittsdarstellung eines Halbleiterleistungsbauelements gemäß einer vierten Ausführungsform der vorliegenden Erfindung; |
| Fig. 5a-e | eine Darstellung der wesentlichen Prozeßschritte einer Ausführungsform des erfindungsgemäßen Herstellungsverfahrens für das Halbleiterleistungsbauelement gemäß der ersten bzw. zweiten Ausführungsform; |
| Fig. 6a-e | eine Darstellung der wesentlichen Prozeßschritte einer Ausführungsform des erfindungsgemäßen Herstellungsverfahrens für das Halbleiterleistungsbauelement gemäß der dritten bzw. vierten Ausführungsform; |
| Fig. 7 | eine schematische Querschnittsdarstellung eines bekannten SC-NPT-EST; |
| Fig. 8 | eine schematische Querschnittsdarstellung eines bekannten DC-NPT-EST; |
| Fig. 9 | eine schematische Querschnittsdarstellung eines bekannten SC-PT-EST; |
| Fig. 10 | eine schematische Querschnittsdarstellung eines bekannten DC-PT-EST; und |
| Fig.11 | eine übliche Schaltungstopologie, in der ein EST als Zündschalter im Primärkreis einer Zündspule für eine Brennkraftmaschine verwendet wird. |

BESCHREIBUNG DER AUSFÜHRUNGSBEISPIELE

In den Figuren bezeichnen gleiche Bezugszeichen gleiche oder funktionsgleiche Komponenten.

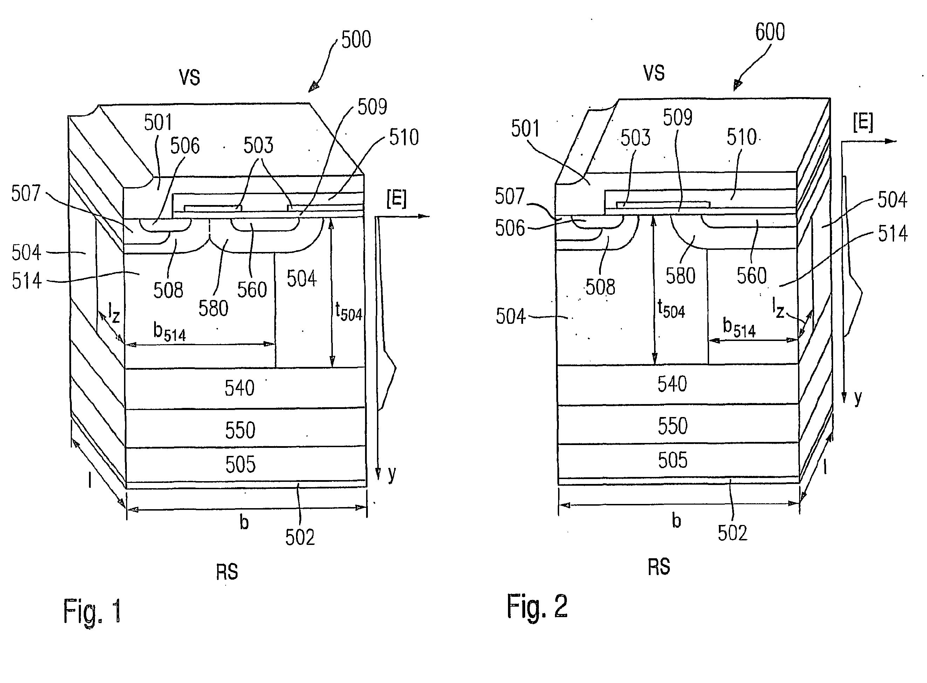

Fig. 1 zeigt eine schematische Querschnittsdarstellung eines Halbleiterleistungsbauelements gemäß einer ersten Ausführungsform der vorliegenden Erfindung.

Für die nachfolgende Beschreibung ist es vorteilhaft, den Kompensationsgrad K(y) wie folgt einzuführen:

$$K(y) = Sp(y)/Sn(y) - 1$$

Hierbei ist y die von der ersten Halbleiteroberfläche in die Richtung der Chiprückseite weisende Koordinate und

$$Sn(y) \quad = \quad \iint ND(x, y, z)\, dx\, dz$$

$$Sp(y) \quad = \quad \iint NA(x, y, z)\, dx\, dz$$

Die Integration ist hier jeweils in den kartesischen, zu y orthogonalen Koordinaten x und z über das gesamte aktive Gebiet des Bauelements zu erstrecken, das sich aus einer Vielzahl parallelgeschalteter Zellen zusammensetzt (Querschnitt jeweils einer halben Zelle siehe Fig. 1 - Fig. 4). ND(x,y,z) und NA(x,y,z) sind die Donator- bzw. Akzeptorkonzentration in einem Punkt P(x,y,z) innerhalb des Bauelements.

Fig. 1 zeigt einen Ausschnitt 500 der Breite b und der Länge 1 aus dem aktiven Gebiet eines ESTs. Wesentlich ist, dass im Bereich der nebeneinander angeordneten n/p-Driftgebiete 504 bzw. 514 ein Kompensationsgrad K(y) > 1 eingestellt ist, der im Bereich des von der vorderseitigen Halbleiteroberflächen entfernten Endes des p-Driftgebiets 514 ein Maximum aufweist. Das gesamte aktive Gebiet erhält man durch mehrmaliges Spiegeln der skizzierten Struktur an ihren Begrenzungsflächen.

In Fig. 1 ist 501 die Kathodenmetallisierung, 502 die Anodenmetallisierung, 503 das zweigeteilte Gate, dessen zwei Teile über die dritte Dimension miteinander verbunden sind und das vorzugsweise aus Polysilizium besteht, 514 das p-Driftgebiet der Breite $b_{514}$ und Länge $l_z$, 504 ein erster Teil des n-Driftgebiets der Tiefe $t_{504}$ mit wahlweise nicht konstanter Dotierung, 540 ein zweiter Teil des n-Driftgebiets mit wahlweise gegenüber 504 unterschiedlicher Dotierungskonzentration, 550 ein optionales n-Gebiet mit gegenüber 540 erhöhter Dotierungskonzentration, das beispielsweise als Buffer dienen kann, 505 ein als Emitter dienendes $p^+$-Gebiet, 506 ein $n^+$-dotiertes Sourcegebiet, 560 ein $n^+$-dotiertes Emittergebiet, 507 eine $p^+$-Kontaktdiffusion, die sich teilweise unter 506 erstreckt und zusätzlich zur Herabsetzung der Latch-up-Empfindlichkeit des ESTs dient, 508 und 580 ein erstes bzw. zweites p-Bodygebiet, an deren von Gateoxid 509 bedeckter Oberfläche ein Inversionskanal ausbildbar ist und 510 ein Zwischenoxid, das zur Isolation zwischen 501 und 503 dient.

Die nach dem Stand der Technik üblichen, auf der Kathodenmetallisierung 501 angeordneten Passivierungsschichten aus Nitrid oder Polyimid sind hier aus Klarheitsgründen nicht eingezeichnet. Für die Dimensionen des p-Driftgebiets 514 gilt allgemein $l_z$ kleiner oder gleich l und $b_{514}$ kleiner oder gleich b, wobei $l_z$ und $b_{514}$ stets so zu wählen sind, dass ein durchgängiger vertikaler Pfad des n-Driftgebiets 504 von der vorderseitigen Halbleiteroberfläche zum Gebiet 540 erhalten bleibt, über den ein Stromfluss von Elektronen möglich ist.

Generell.ist denkbar, die Breite $b_{514}$ und/oder Länge $l_z$ und/oder die Dotierungen von 504, 514 nicht in jeder Halbzelle identisch auszuführen, so dass z.B. nicht jede Halbzelle mit einem p-Driftgebiet 514 ausgerüstet ist. Für eine homogene Funktionalität der einzelnen Halbzellen untereinander ist dies jedoch nicht unbedingt anzustreben. Für die nachfolgende Erläuterung der Funktion wird deshalb vereinfachend davon ausgegangen, dass alle Halbzellen im aktiven Gebiet identisch ausgeführt sind.

Im Durchlassfall ist die Funktion ist analog zum SC-EST nach dem Stand der Technik. Das nur mittels einer dünnen Gateoxidschicht 509 vom Halbeiter isolierte Gate 503 wird gegenüber dem Kathodenanschluß 501 auf ein Potential oberhalb der Schwellspannung der MOS-Steuerköpfe gebracht. Daraufhin wird im Bereich der p-Bodygebiete 508, 580 und, sofern $b_{514}$ entsprechend breit ist, des p-Driftgebiets 514 ein Inversionskanal an der Halbleiteroberfläche unter dem Gateoxid 509 erzeugt. Die Halbleiteroberfläche im Bereich des n-Driftgebiets 504 befindet sich dann im Zustand der Akkumulation.

Bei einer gegenüber dem Kathodenanschluß 501 positiven Anodenspannung am Anodenanschluß 502 werden Elektronen über die $n^+$-Gebiete 506, die influenzierten MOS-Kanäle und die Akkumulationsschicht in das n-Driftgebiet 504 injiziert. Daraufhin injiziert der anodenseitige $p^+$-Emitter 505 Löcher. Ab einer bestimmten Stromdichte zündet die aus den Gebieten 560, 580, 514, 504, 540, 550, 505 bestehende Thyristorstruktur, wodurch das $n^-$-Driftgebiet 540 und, je nach Höhe der Dotierung, auch die p/n-Driftgebiete 514 bzw. 504 derart von'Ladungsträgern überschwemmt werden, dass die Leitfähigkeit über den Mechanismus der Hochinjektion erhöht wird. Somit sind gute Durchlasseigenschaften erreichbar. Der Strom durch den EST bleibt dabei über die Gate-Kathoden-Spannung steuerbar.

Die Funktionsweise im Sperrfall verläuft folgendermaßen. Das Gate 503 wird gegenüber dem Kathodenanschluß 501 auf eine Spannung unterhalb der Schwellspannung gebracht. Bringt man den Anodenanschluß 502 nun auf ein positives Potential, dehnt sich die an der Grenze zwischen dem p-Driftgebiet 514 und den n-Driftgebieten 504, 540 ausgebildete Raumladungszone wegen K(y)>1 stärker in die n-Driftgebiete 504, 540 als ins p-Driftgebiet 514 aus. Erst für große Sperrspannungen in der Größenordnung der Durchbruchspannung wird das p-Driftgebiet 514 vollständig von Ladungsträgern ausgeräumt.

Für den Fall einer NPT(Non-Punch-Through)-Struktur entfällt das Gebiet 550 und die Dicke der $n^-$-Driftzone 540 ist größer gewählt, als die Weite, die die Raumladungszone bei einer vorgegebenen maximalen Sperrfähigkeit des Bauelements in der $n^-$-Driftzone 540 aufweist.

Dies führt zu dem in Fig. 1 angedeuteten Verlauf des elektrischen Feldstärke |E| entlang der y-Koordinate. Wesentlich ist, dass das Maximum der Feldstärke sich nicht im Bereich der MOS-Steuerköpfe, sondern etwa einer Tiefe $t_{504}$ am Boden des p-Driftgebiets 514 befindet. Dies wird grundsätzlich durch den gewählten Kompensationsgrad K(y) >1 erreicht. Ferner werden hohe Feldstärken im Bereich des MOS-Steuerkopfes wirkungsvoll dadurch verhindert, dass der Kompensationsgrad K(y) sein Maximum im Bereich des von der vorderseitigen Halbleiteroberfläche entfernten Endes des p-Driftgebiets 514 hat.

Bei einer PT(Punchthrough)-Struktur ist das n-Gebiet 550 vorhanden und kann entweder dazu benutzt werden, den Emitterwirkungsgrad und das Schaltverhalten zu optimieren, und/oder die Dicke der $n^-$-Driftzone 540 ist kleiner gewählt, als die Weite, die die Raumladungszone bei einer gegebenen maximalen Sperrfähigkeit des Bauelements in der $n^-$-Driftzone 540 aufweisen würde. Dann kann das n-Gebiet 550 dazu verwendet werden, ein Auflaufen der Raumladungszone auf den $p^+$-Emitter 505 zu verhindern.

Dies führt zu einem dem in Fig. 1 ähnlichen Verlauf des elektrischen Feldstärke |E| entlang der y-Koordinate, wobei das Feld aber nicht weit in das n-Gebiet 550 eindringt. Wesentlich ist, dass auch in diesem Fall das Maximum der Feldstärke weit entfernt vom MOS-Steuerkopfbereich etwa in einer Tiefe $t_{504}$ am Boden des p-Driftgebiets 514 liegt.

Zur Darstellung des Impulsfalls wird der EST in einer Schaltung gemäss Fig. 11 betrieben, und es wird wiederum angenommen, dass kein Zündfunke erzeugbar ist. Die Funktionsweise ist analog zu dem EST gemäss dem Stand der Technik. Durch die spezielle Struktur des erfindungsgemäßen EST liegt das Feldmaximum und die Stelle höchster Wärmegeneration bei ihm jedoch in der Tiefe des Halbleiters. Somit dauert es eine gewisse Zeit, bis der MOS-Steuerkopfbereich nach Einsetzen des Impulsfalles von der Hitzefront erfasst wird und es kommt erst deutlich später zu dem oben beschriebenen Effekt thermischer Mitkopplung, der die Zerstörung des Bauelements einleitet. Durch diese zusätzliche Zeit, die der EST gemäß dieser Ausführungsform im Impulsfall überlebt, erreicht er gegenüber dem EST nach dem Stand der Technik eine deutlich erhöhte Impulsfestigkeit.

Fig. 2 zeigt eine schematische Querschnittsdarstellung eines Halbleiterleistungsbauelements gemäß einer zweiten Ausführungsform der vorliegenden Erfindung.

Die zweite Ausführungsform 600 des erfindungsgemäßen ESTs mit oder ohne n-Gebiet 550 in Fig. 2 zeigt einen DC-EST, dessen Funktionsweise analog zu derjenigen der Struktur in Fig. 1 sind. Die in Fig. 2 dargestellten Struktur 600 hat jedoch vorteilhafterweise einen höheren FBSOA. Bei der Struktur 600 grenzt das p-Driftgebiet 514 unmittelbar an das zweite p-Bodygebiet 580. Wesentlich ist hierbei, dass die Dimensionen $b_{514}$, $l_z$ so gewählt sind, dass ein durchgängiger vertikaler Pfad des Gebiets 504 von der ersten Halbleiteroberfläche zum Gebiet 540 erhalten bleibt, über den ein Stromfluss von Elektronen möglich ist. Generell ist denkbar, die Breite $b_{514}$ und/oder Länge $l_z$ und/oder die Dotierungen von 504, 514 nicht in jeder Halbzelle identisch auszuführen, so dass z.B. nicht jede Halbzelle mit einem p-Gebiet 514 ausgerüstet ist. Für eine homogene Funktionalität der einzelnen Halbzellen untereinander ist dies jedoch nicht anzustreben..

Zwei weitere bevorzugte Ausführungsformen des erfindungsgemäßen Halbleiterleistungsbauelements lassen sich aus Fig. 1 und Fig. 2 dadurch ableiten, dass man $b_{514}$=b und $l_z$<l wählt. Diese Varianten haben, wie später im Zusammenhang mit Fig. 5a-e erläutert wird, Vorteile bei der Herstellung.

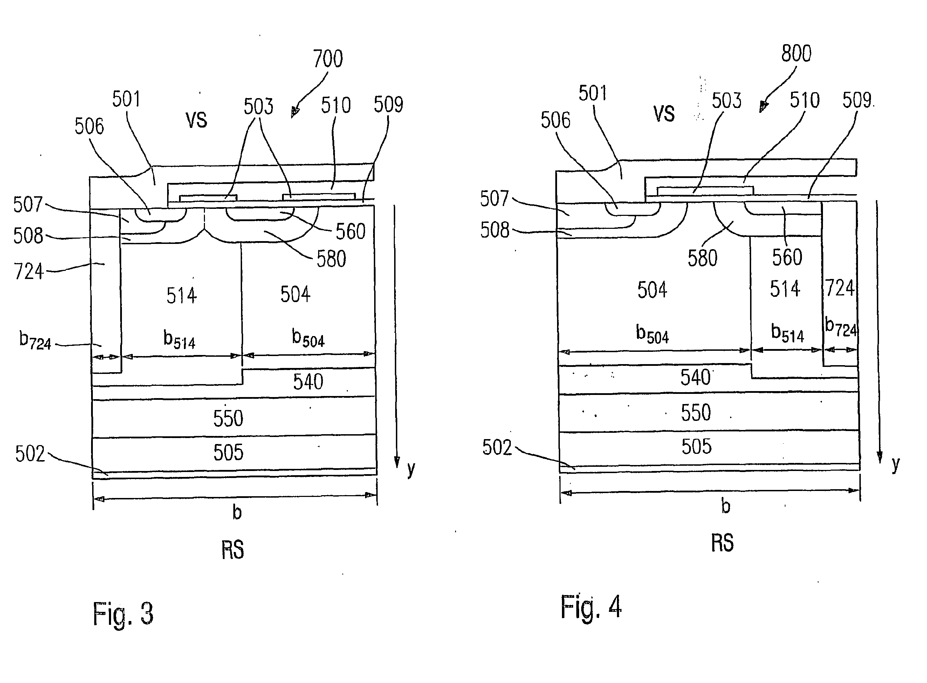

Fig. 3 und 4 zeigen eine jeweilige schematische Querschnittsdarstellung eines Halbleiterleistungsbauelements gemäß einer dritten bzw. vierten Ausführungsform der vorliegenden Erfindung mit optionalem n-Gebiet 550, und zwar Fig. 3 als SC-EST und Fig, 4 als DC.EST.

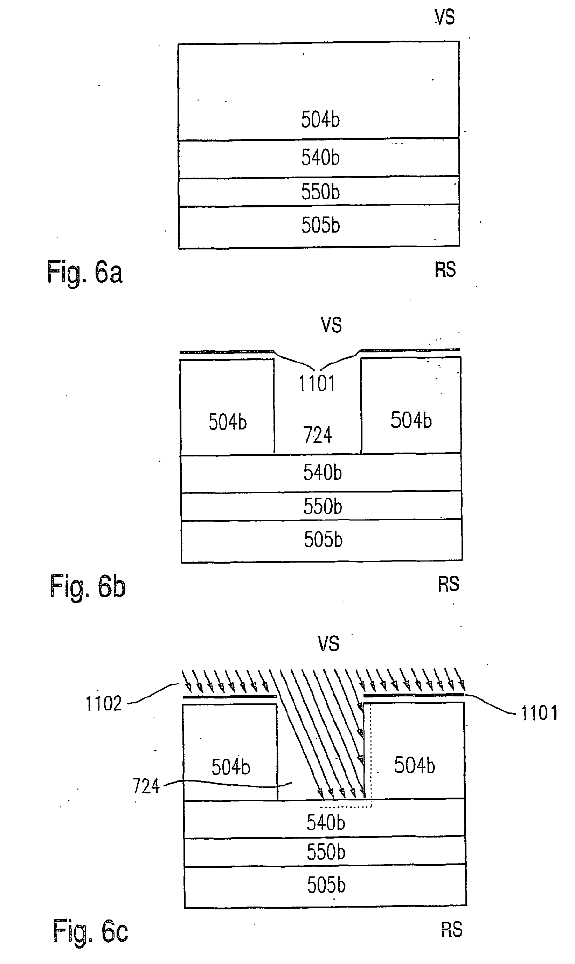

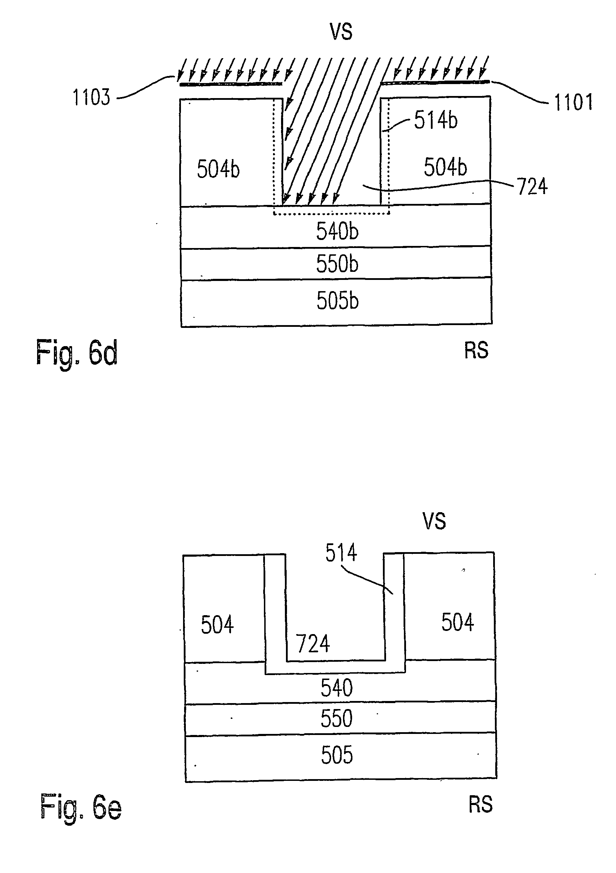

Bei diesen, analog zu Fig. 1 und Fig. 2 funktionierenden Strukturen sind die p-Driftgebiete 514 mittels eines tiefen Trenches bzw. Grabens 724 hergestellt, der wahlweise mit Dielektrikum oder Polysilizium gefüllt werden kann. Ein möglicher Prozessfluss zur Herstellung wird später im Zusammenhang mit Fig. 6a-e erläutert. Für die in Fig. 3 und 4 dargestellten Strukturen ist wesentlich, dass der Kompensationsgrad K(y)>1 so eingestellt ist, dass er im Bereich des von der ersten Halbleiteroberfläche entfernten Endes der p-Driftgebiete 514 ein Maximum aufweist und ferner, dass ein durchgängiger vertikaler Pfad des Gebiets 504 von der vorderseitigen Halbleiteroberfläche zum n⁻-Driftgebiet 540 erhalten bleibt, über den ein Stromfluss von Elektronen möglich ist.

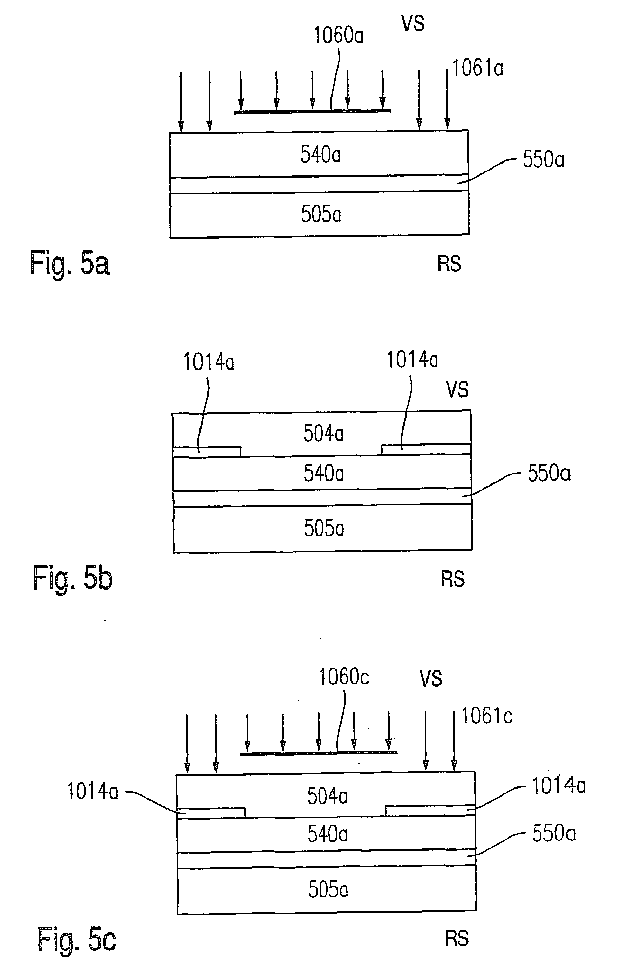

Fig. 5a-e zeigen eine Darstellung der wesentlichen Prozeßschritte einer Ausführungsform des erfindungsgemäßen Herstellungsverfahrens für das Halbleiterleistungsbauelement gemäß der ersten bzw. zweiten Ausführungsform.

Ausgangspunkt ist z.B. ein p⁺-Substrat 505a mit einer optional darauf erzeugten ersten n-Schicht 550a, auf die per Epitaxie ein Teil des n⁻-Driftgebiets 540a abgeschieden wurde.

Alternativ kann auch ein n-Substrat mit p⁺-Rückseiten-diffusion oder ein n-Substrat mit p⁺-Epitaxieschicht verwendet werden.

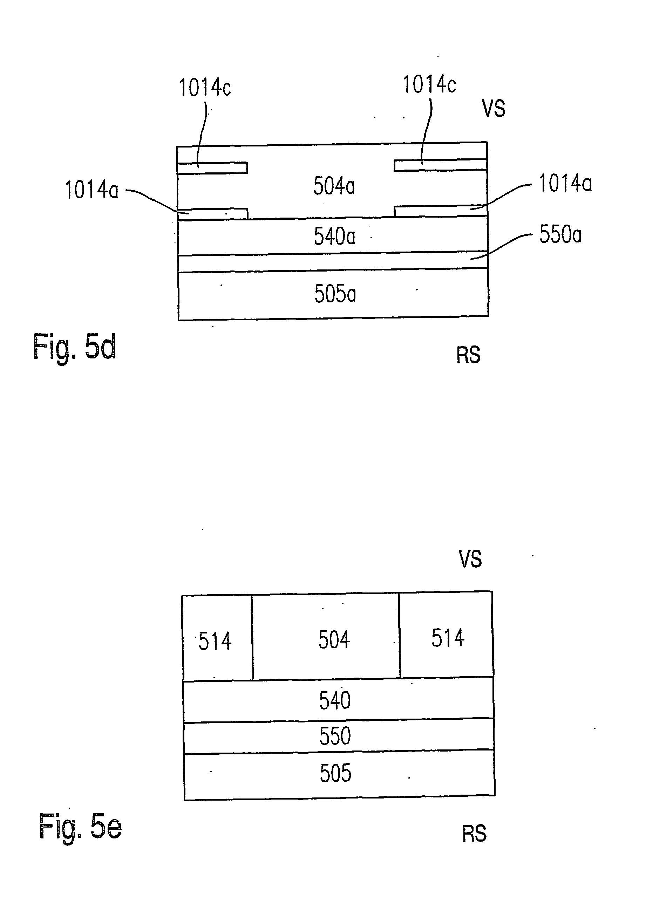

Im Fig. 5a dargestellten nachfolgenden Arbeitsgang wird eine p-Schicht 1061a implantiert, die mittels einer Fotomaske 1060a strukturiert wird. Anschließend erfolgt, wie Fig. 5b gezeigt, das Aufwachsen einer Teildicke des n-Driftgebiets 504a, wobei die zuvor implantierten p-Gebiete 1014a bis zu einem gewissen Grade ausdiffundieren. Wie in Fig. 5c gezeigt, erfolgt nun eine erneute, mittels Fotomaske 1060c strukturierte p-Implantation 1061c oberhalb der Gebiete 1014a zur Erzeugung der p-Gebiete 1014c. Anschließend erfolgt ein epitaktisches Aufwachsen einer weiteren Teildicke des n-Driftgebiets 504a, wobei die zuvor eingebrachten p-Gebiete 1014a, 1014c wiederum etwas ausdiffundieren. Diese Arbeitsschrittsequenz Implantation mit nachfolgender Epitaxie wird solange wiederholt, bis das n-Driftgebiet 504a seine Zieldicke erreicht hat (s. Fig. 5d), die beispielsweise auf Basis der gewünschten Impulsfestigkeit definiert werden kann.

Der gewünschte Kompensationsgrad K(y) lässt sich dabei durch eine entsprechende Wahl der Implantationsdosen und/oder Fensterweiten in den Fotomasken und/oder variablen Dotierung während der Epitaxie einstellen.

Auf dem so vorprozessierten Wafer lassen sich mit Standardfertigungsverfahren der Halbleitertechnik anschließend alle weiteren zur Darstellung des EST gemäß der ersten oder. zweiten Ausführungsform nötigen Strukturen aus dem Wafer herstellen.

Gegenüber dem in DE 196 04 043 A1 vorgeschlagenen Verfahren ist der hier beschriebene Herstellungsprozess weniger aufwendig, da nur die p-Dotierungen mittels Fotomaske zu strukturieren sind. Die für die Funktion nötige n-Dotierung wird direkt mittels Epitaxie zur Verfügung gestellt.

Es erfolgt schließlich, wie in Fig. 5e gezeigt, ein Eintreibschritt, bei dem die zuvor implantierten p-Gebiete 1014a, 1014c ausdiffundieren. Dabei verschmelzen sie, wie dargestellt, miteinander zur Bildung des p-Driftgebiets 514.

Aus den Bereichen 505a, 550a, 540a und 504a werden dann die entsprechenden Bereiche 505, 550, 540, 504, die oben mit Bezug auf Fig.' 1 und 2 erläutert wurden. Die Erstellung der MOS-Steuerköpfe erfolgt schließlich in bekannter Art und Weise.

Ziel eines solchen effektiven Herstellungsverfahrens ist es, mit möglichst wenigen Implantations-/Epitaxiesequenzen auszukommen. Diesem Wunsch sind aber bei dem Entwicklungstrend zu immer kleineren Halbzellweiten Grenzen gesetzt. Möchte man nämlich, aus Gründen der Homogenität der physikalischen Vorgänge im aktiven Gebiet des EST, jeder Halbzelle ein identisches p-Driftgebiet zuordnen und dieses mit möglichst wenigen Implantations-/Epitaxiesequenzen erzeugen, so ist eine große vertikale Ausdiffusion der implantierten p-Gebiete zu wählen. Dies bedeutet aber im Gegenzug wegen $K(y)>1$ auch eine große laterale Ausdiffusion.

Damit sind unter obigen Randbedingungen einer Zellverkleinerung Grenzen gesetzt. Diese Schwierigkeit lässt sich dadurch umgehen, dass man in einer Anordnung mit streifenförmigen p-Body-Gebieten 508, 580 die p-Driftgebiete 514 ebenfalls streifenförmig ausführt und nicht parallel zu diesen anordnet, sondern in einem z.B. vorzugsweise rechten Winkel.

Dies wird in Fig. 1 und Fig. 2 dadurch erreicht, indem man $b_{514}=b$ und $l_z<l$ wählt. Diese Art der Anordnung von MOS-Steuerköpfen und Kompensationsstrukturen (p-Driftgebieten) zueinander ist nicht auf ESTs beschränkt, sondern kann auch bei anderen vertikalen Bauelementen; wie z.B. vertikalen MOS-Transistoren mit Kompensationsstrukturen, eingesetzt werden.

Fig. 6a-e zeigen eine Darstellung der wesentlichen Prozeßschritte einer Ausführungsform des erfindungsgemäßen Herstellungsverfahrens für das Halbleiterleistungsbauelement gemäß der dritten bzw. vierten Ausführungsform.

In einen Wafer gemäß Fig. 6a mit der Schichtenfolgen-Driftgebiet 504b, n-Gebiet 540b, optionalem n-Gebiet 550b und p$^+$-Emitter 505b werden, gemäss Fig. 6b, von der Waferoberseite her Gräben 724 geätzt, wobei eine Maske 1101 zur Strukturabbildung genutzt wird. Diese können senkrecht verlaufende parallele Seitenwände haben. Sie können aber auch schräge Seitenwände haben, so dass sie im Querschnitt V-förmig sind oder U-förmig mit nach oben größer werdender Breite sind.

Mittels zweier aufeinanderfolgender p-Implantationen 1102, 1103 unter zur y-Richtung entgegengesetzt gleich großen Winkeln lassen sich in die Wände und den Boden der Gräben 724 p-Dbtierungen 514c, 514d derart einbringen, so dass $K(y)>1$ ist. Durch eine entsprechende Wahl von Grabenbreite und Implantationswinkel lässt sich ferner erreichen, dass der Kompensationsgrad auf der Höhe des Bodens der Gräben 724 ein Maximum hat. Anschließend lassen sich nach dem Entfernen der Maske 1101 und Auffüllen der Gräben 724, z.B. mit einem Dielektrikum, durch Ausdiffusion die p-Gebiete 514 erzeugen. Aus den Gebieten 505b, 550b, 540b, 504b werden dann die entsprechenden Bereiche 505, 550, 540 und 504, die oben mit Bezug auf Fig. 3 und 4 erläutert wurden. Die Erstellung der MOS-Steuerköpfe erfolgt schließlich in bekannter Art und Weise mittels Standardprozessschritten der. Halbleitertechnik.

Zur Optimierung der dynamischen Eigenschaften des Bauelements lassen sich in die Prozessflüsse gemäss Fig. 5a-e oder Fig. 6a-e trägerlebensdauerreduzierende Prozessschritte einfügen.

Obwohl die vorliegende Erfindung vorstehend anhand eines bevorzugten Ausführungsbeispiels beschrieben wurde, ist sie darauf nicht beschränkt, sondern auf vielfältige Weise modifizierbar.

Vertauscht man z.B. die Dotierungsarten und die Vorzeichen der anzulegenden Spannung, erhält man aus dem n-Kanal-EST einen entsprechenden p-Kanal-EST. Allgemein ist dieser dem n-Kanal-EST hinsichtlich der Latch-up-Festigkeit überlegen, aber hinsichtlich der Avalanche-Festigkeit unterlegen.

**Patentansprüche**

1.  Halbleiterleistungsbauelement mit:

    einem rückseitigen Anodenkontakt (502);
    einem rückseitigen Emitterbereich (505) eines ersten Leitungstyps p$^+$, welcher mit dem rückseitigen Anodenkontakt (502) verbunden ist;
    einem Driftgebiet (504, 514, 540), welches mit dem rückseitigen Emitterbereich (505) verbunden ist und teilweise an die vorderseitige Oberfläche reicht;
    einer vorderseitigen MOS-Steuerstruktur (503, 506, 560, 508, 580, 509) mit einem Sourcebereich (506) des zweiten Leitungstyps n$^+$ und einem ersten Bodybereich (508) des ersten Leitungstyps p einem Emitterbereich (560) des zweiten Leitungstyps n$^+$, der P von einem zweiten Bodybereich (580) des ersten Leitungstyps p umschlossen ist,
    welche in das Driftgebiet (504, 514, 540) eingebracht sind, wobei der zweite Bodybereich (580) an den ersten Bodybereich (508) angrenzt, und einem isoliert angeordneten Steuerkontakt (503), welcher über dem zweiten Bodybereich (580) und über einem daran angrenzenden an die vorderseitige Oberfläche reichenden Teil (504, 514) des Driftgebiets (504, 514, 540) sowie über dem ersten und zweiten Bodybereich (508, 580) zwischen dem Sourcebereich (506) und dem Emitterbereich (560) angeordnet ist; und

einem vorderseitigen Kathodenkontakt (501), welcher mit dem Sourcebereich (506) und dem ersten Bodybereich (508) verbunden ist;

wobei

das Driftgebiet (504, 514, 540) einen ersten Driftbereich (540) des zweiten Leitungstyps $n^-$, en einen zweiten Driftbereich (504) des zweiten Leitungstyps n und einen dritten Driftbereich (514) des ersten Leitungstyps p aufweist;

der erste Driftbereich (540) ein vergrabener Bereich ist;

der zweite Driftbereich (504) die vorderseitige Oberfläche mit dem ersten Driftbereich (540) verbindet;

der dritte Driftbereich (514) das erste und zweite Bodygebiet (508, 580) mit dem ersten Driftbereich (540) verbindet; und

der aus dem zweiten und dritten Driftbereich (504, 514) ermittelbare Kompensationsgrad (K(y)) größer als eins ist und im Bereich der von der vorderen Oberfläche abgewandten Seite des dritten Driftbereichs (514) ein Maximum aufweist und

für den Kompensationsgrad K(y) gilt:

$$K(y) = Sp(y)/Sn(y)-1$$

wobei y die von der ersten Halbleiteroberfläche in die Richtung der Chiprückseite weisende Koordinate ist und weiter gilt:

$$Sn(y) \quad = \quad \iint ND(x,y,z)dxdz$$

$$Sp(y) \quad = \quad \iint NA(x,y,z)dxdz$$

und ND(x,y,z) und NA(x,y,z) die Donator- bzw. Akzeptorkonzentration in einem Punkt P(x,y,z) innerhalb des Bauelements sind.

2. Halbleiterleistungsbauelement mit einem rückseitigen Anodenkontakt (502); einem rückseitigen Emitterbereich (505) eines ersten Leitungstyps $p^+$, welcher mit dem rückseitigen Anodenkontakt (502) verbunden ist;

einem Driftgebiet (504, 514, 540), welches mit dem rückseitigen Emitterbereich (505) verbunden ist und teilweise an die vorderseitige Oberfläche reicht;

einer vorderseitigen MOS-Steuerstruktur (503, 506, 560, 508, 580, 509) mit einem Sourcebereich (506) des zweiten Leitungstyps $n^+$ und einem ersten Bodybereich (508) des ersten Leitungstyps p, einem Emitterbereich (560) des zweiten Leitungstyps $n^+$, der von einem zweiten Bodybereich (580) des ersten Leitungstyps p umschlossen ist, welche in das Driftgebiet (504, 514, 540) eingebracht sind, wobei der erste und zweite Bodybereich (508, 580) voneinander beabstandet sind, und einem isoliert angeordneten Steuerkontakt (503), welcher über dem ersten und zweiten Bodybereich (508, 580) und über einem dazwischenliegenden an die vorderseitige Oberfläche reichenden Teil (504, 514) des Driftgebiets (504) angeordnet ist; und

einem vorderseitigen Kathodenkontakt (501), welcher mit dem Sourcebereich (506) und dem ersten Bodybereich (508) verbunden ist;

wobei

das Driftgebiet (504, 514, 540) einen ersten Driftbereich (540) des zweiten Leitungstyps $n^-$, einen zweiten Driftbereich (504) des zweiten Leitungstyps n und einen dritten Driftbereich (514) des ersten Leitungstyps p aufweist;

der erste Driftbereich (540) ein vergrabener Bereich ist;

der zweite Driftbereich (504) den zwischen dem ersten und zweiten Bodybereich (508, 580) liegenden Bereich der Oberfläche mit dem ersten Driftbereich (540) verbindet;der dritte Driftbereich (514) das zweite Bodygebiet (580) mit dem ersten Driftbereich (540) verbindet; und

der aus dem zweiten und dritten Driftbereich (504, 514) ermittelbare Kompensationsgrad (K(y)) größer als eins ist und im Bereich der von der vorderen Oberfläche abgewandten Seite des dritten Driftbereichs (514) ein Maximum aufweist und

für den Kompensationsgrad K(y) gilt:

$$K(y)=Sp(y)/Sn(y)-1$$

wobei y die von der ersten Halbleiteroberfläche in die Richtung der Chiprückseite weisende Koordinate ist und weiter gilt:

$$Sn(y) \quad = \quad \iint ND(x,y,z)dxdz$$

$$Sp(y) \quad = \quad \iint NA(x,y,z)dxdz$$

und ND(x,y,z) und NA(x,y,z) die Donator- bzw. Akzeptorkonzentration in einem Punkt P(x,y,z) innerhalb des Bauelements sind.

3. Halbleiterleistungsbauelement nach Anspruch 1 oder 2, **dadurch gekennzeichnet, dass** zwischen dem ersten Driftbereich (540) und dem rückseitigen Emitterbereich (505) ein Buffergebiet (550) des zweiten Leitungstyps vorgesehen ist.

4. Halbleiterleistungsbauelement nach Anspruch 1, 2 oder 3, **dadurch gekennzeichnet, dass** ein Kontaktgebiet (507) des ersten Leitungstyps, das sich teilweise unter den Sourcebereich (506) erstreckt, den Sourcebereich (506) teilweise umschließt.

5. Halbleiterbauelement nach einem der vorhergehenden Ansprüche, **dadurch gekennzeichnet, dass** der erste Bodybereich (508) und der Sourcebereich (506) einerseits und der dritte Driftbereich (514) andererseits streifenförmig verlaufen und nicht parallel zueinander verlaufen.

6. Halbleiterleistungsbauelement nach einem der vorhergehenden Ansprüche, **dadurch gekennzeichnet, dass** der dritte Driftbereich (514) einen mit einem Isolationsmaterial gefüllten Graben (724) umschließt.

7. Verfahren zur Herstellung eines Halbleiterleistungsbauelements nach Anspruch 1 oder 2 mit den Schritten:

a) Bereitstellen eines Substrats mit einem rückseitigen Bereich (505a) des ersten Leitungstyps entsprechend dem rückseitigen Emitterbereich (505) und einem vorderseitigen Bereich (540a) des zweiten Leitungstyps (n⁻) entsprechend dem ersten Driftbereich (540);
b) Bilden einer Maske (1060a) auf der Vorderseite des Substrats;
c) Einbringen eines ersten Bereichs (1014a) des ersten Leitungstyps mittels der Maske (1060a);
d) Aufwachsen eines Bereichs (504a) des zweiten Leitungstyps auf der Vorderseite des Substrats;
e) optionelles Wiederholen der Schritte c) und d);
f) Ausdiffundieren des oder der Bereiche (1014a, 1014c) des ersten Leitungstyps (p) zum Bilden des dritten Driftbereichs (514);
g) Erstellen der vorderseitigen MOS-Steuerstruktur (503, 506, 560, 508, 580, 509); und
h) Bilden des rückseitigen Anodenkontakts (502) und des vorderseitigen Kathodenkontakts (501).

8. Verfahren zur Herstellung eines Halbleiterleistungsbauelements nach Anspruch 1 oder 2 mit den Schritten:

a') Bereitstellen eines Substrats mit einem rückseitigen Bereich (505b) des ersten Leitungstyps entsprechend dem rückseitigen Emitterbereich (505), einem vorderseitigen Bereich (504b) entsprechend dem zweiten Driftbereich (504) und einem mittleren Bereich (540b) des zweiten Leitungstyps entsprechend dem ersten Driftbereich (540);
b') Bilden eines Grabens (724) auf der Vorderseite des Substrats, der bis zum mittleren Bereich (540b) des zweiten Leitungstyps entsprechend dem ersten Driftbereich (540) reicht;
c') Bilden einer Maske (1001) auf der Vorderseite des Substrats;

d') Einbringen eines ersten Bereichs (514c,d) des ersten Leitungstyps entsprechend dem dritten Driftbereich (514) in die Grabenwände und den Grabenboden;

e') Auffüllen des Grabens (724) mit einem Isolationsmaterial;

f') Erstellen der vorderseitigen MOS-Steuerstruktur (503, 506, 560, 508, 580, 509); und

g') Bilden des rückseitigen Anodenkontakts (502) und des vorderseitigen Kathodenkontakts (501).

9. Verfahren nach Anspruch 7 oder 8, **dadurch gekennzeichnet, dass** zwischen dem rückseitigen Bereich (505a) des ersten Leitungstyps entsprechend dem rückseitigen Emitterbereich (505) und dem vorderseitigen Bereich (540a) des zweiten Leitungstyps entsprechend dem ersten Driftbereich (540) ein Bereich (550a, 550b) des zweiten Leitungstyps entsprechend einem Buffergebiet (550) vorgesehen wird.

**Claims**

1. Semiconductor power component comprising:

a rear-side anode contact (502);

a rear-side emitter region (505) of a first conduction type $p^+$, which is connected to the rear-side anode contact (502);

a drift zone (504, 514, 540), which is connected to the rear-side emitter region (505) and partly extends to the front-side surface;

a front-side MOS control structure (503, 506, 560, 508, 580, 509) comprising a source region (506) of the second conduction type $n^+$ and a first body region (508) of the first conduction type p, an emitter region (560) of the second conduction type $n^+$, which is enclosed by a second body region (580) of the first conduction type p, which are introduced into the drift zone (504, 514, 540), wherein the second body region (580) adjoins the first body region (508), and a control contact (503) arranged in an insulated fashion, which control contact is arranged above the second body region (580) and above a part (504, 514) of the drift zone (504, 514, 540), said part adjoining said second body region and extending to the front-side surface, and also above the first and second body regions (508, 580) between the source region (506) and the emitter region (560); and a front-side cathode contact (501), which is connected to the source region (506) and to the first body region (508) ;

wherein

the drift zone (504, 514, 540) has a first drift region (540) of the second conduction type $n^-$, a second drift region (504) of the second conduction type n and a third drift region (514) of the first conduction type p;

the first drift region (540) is a buried region;

the second drift region (504) connects the front-side surface to the first drift region (540);

the third drift region (514) connects the first and second body regions (508, 580) to the first drift region (540); and

the degree of compensation (K(y)) which can be determined from the second and third drift regions (504, 514) is greater than one and has a maximum in the region of that side of the third drift region (514) which faces away from the front surface, and

the following holds true for the degree of compensation K(y) :

$$K(y)=Sp(y)/Sn(y)-1$$

wherein y is the coordinate facing from the first semiconductor surface in the direction of the chip rear side and the following furthermore holds true:

$$Sn(y) = \iint ND(x,y,z)\,dxdz$$

$$Sp(y) = \iint NA(x,y,z)\,dxdz$$

EP 1 384 269 B1

and ND(x,y,z) and NA (x, y, z) are the donnar and acceptor concentration, respectively, at a point P(x,y,z) within the component.

2.  Semiconductor power component comprising a rear-side anode contact (502); a rear-side emitter region (505) of a first conduction type $p^+$, which is connected to the rear-side anode contact (502);
a drift zone (504, 514, 540), which is connected to the rear-side emitter region (505) and partly extends to the front-side surface;
a front-side MOS control structure (503, 506, 560, 508, 580, 509) comprising a source region (506) of the second conduction type $n^+$ and a first body region (508) of the first conduction type p, an emitter region (560) of the second conduction type $n^+$, which is enclosed by a second body region (580) of the first conduction type p, which are introduced into the drift zone (504, 514, 540), wherein the first and second body regions (508, 580) are spaced apart from one another, and a control contact (503) arranged in an insulated fashion, which control contact is arranged above the first and second body regions (508, 580) and above a part (504, 514) of the drift zone (504), said part being situated between said body regions and extending to the front-side surface; and
a front-side cathode contact (501), which is connected to the source region (506) and to the first body region (508); wherein
the drift zone (504, 514, 540) has a first drift region (540) of the second conduction type n⁻, a second drift region (504) of the second conduction type n and a third drift region (514) of the first conduction type p;
the first drift region (540) is a buried region;
the second drift region (504) connects that region of the surface which lies between the first and second body regions (508, 580) to the first drift region (540); the third drift region (514) connects the second body region (580) to the first drift region (540); and the degree of compensation (K(y)) which can be determined from the second and third drift regions (504, 514) is greater than one and has a maximum in the region of that side of the third drift region (514) which faces away from the front surface, and
the following holds true for the degree of compensation K(y) :

$$K(y)=Sp(y)/Sn(y)-1$$

wherein y is the coordinate facing from the first semiconductor surface in the direction of the chip rear side and the following furthermore holds true:

$$Sn(y) \;=\; \iint ND(x,y,z)dxdz$$

$$Sp(y) \;=\; \iint NA(x,y,z)dxdz$$

and ND(x,y,z) and NA(x,y,z) are the donor and acceptor concentration, respectively, at a point P(x,y,z) within the component.

3.  Semiconductor power component according to Claim 1 or 2, **characterized in that** a buffer zone (550) of the second conduction type is provided between the first drift region (540) and the rear-side emitter region (505).

4.  Semiconductor power component according to Claim 1, 2 or 3, **characterized in that** a contact zone (507) of the first conduction type, which partly extends below the source region (506), partly encloses the source region (506).

5.  Semiconductor component according to any of the preceding claims, **characterized in that** the first body region (508) and the source region (506), on the one hand, and the third drift region (514), on the other hand, run in strip-shaped fashion and do not run parallel to one another.

6.  Semiconductor power component according to any of the preceding claims, **characterized in that** the third drift region (514) encloses a trench (724) filled with an insulation material.

7.  Method for producing a semiconductor power component according to Claim 1 or 2 comprising the following steps:

a) providing a substrate having a rear-side region (505a) of the first conduction type corresponding to the rear-side emitter region (505) and a front-side region (540a) of the second conduction type (n⁻) corresponding to the first drift region (540);

b) forming a mask (1060a) on the front side of the substrate;

c) introducing a first region (1014a) of the first conduction type by means of the mask (1060a);

d) growing a region (504a) of the second conduction type on the front side of the substrate;

e) optionally repeating steps c) and d);

f) outdiffusing the region or regions (1014a, 1014c) of the first conduction type (p) in order to form the third drift region (514);

g) creating the front-side MOS control structure (503, 506, 560, 508, 580, 509); and

h) forming the rear-side anode contact (502) and the front-side cathode contact (501).

**8.** Method for producing a semiconductor power component according to Claim 1 or 2 comprising the following steps:

a') providing a substrate having a rear-side region (505b) of the first conduction type corresponding to the rear-side emitter region (505), a front-side region (504b) corresponding to the second drift region (504) and a central region (540b) of the second conduction type corresponding to the first drift region (540);

b') forming a trench (724) on the front side of the substrate, said trench extending as far as the central region (540b) of the second conduction type corresponding to the first drift region (540);

c') forming a mask (1001) on the front side of the substrate;

d') introducing a first region (514c, d) of the first conduction type corresponding to the third drift region (514) into the trench walls and the trench bottom;

e') filling the trench (724) with an insulation material;

f') creating the front-side MOS control structure (503, 506, 560, 508, 580, 509); and

g') forming the rear-side anode contact (502) and the front-side cathode contact (501).

**9.** Method according to Claim 7 or 8, **characterized in that** a region (550a, 550b) of the second conduction type corresponding to a buffer zone (550) is provided between the rear-side region (505a) of the first conduction type corresponding to the rear-side emitter region (505) and the front-side region (540a) of the second conduction type corresponding to the first drift region (540).

## Revendications

**1.** Composant de puissance semiconducteur comprenant :

un contact d'anode (502) côté arrière ;

une zone d'émetteur (505) côté arrière d'un premier type de conduction p⁺, laquelle est reliée avec le contact d'anode (502) côté arrière ;

une région de dérive (504, 514, 540) qui est reliée avec la zone d'émetteur (505) côté arrière et qui atteint partiellement la surface du côté avant ;

une structure de commande MOS (503, 506, 560, 508, 580, 509) côté avant, comprenant une zone de source (506) du deuxième type de conduction n⁺ et une première zone de corps (508) du premier type de conduction p, une zone d'émetteur (560) du deuxième type de conduction n⁺, laquelle est entourée par une deuxième zone de corps (580) du premier type de conduction p, lesquelles sont introduites dans la région de dérive (504, 514, 540), la deuxième zone de corps (580) étant adjacente à la première zone de corps (508), et un contact de commande (503) disposé de manière isolée, lequel est disposé entre la zone de source (506) et la zone d'émetteur (560) au-dessus de la deuxième zone de corps (580) et au-dessus d'une partie (504, 514) adjacente à celle-ci de la région de dérive (504, 514, 540) qui atteint la surface du côté avant ainsi qu'au-dessus de la première et de la deuxième zone de corps (508, 580) ; et

un contact de cathode (501) côté avant qui est relié avec la zone de source (506) et la première zone de corps (508) ;

la région de dérive (504, 514, 540) présentant une première zone de dérive (540) du deuxième type de conduction n⁻, une deuxième zone de dérive (504) du deuxième type de conduction n et une troisième zone de dérive (514) du premier type de conduction p ;

la première zone de dérive (540) étant une zone enfouie ;

la deuxième zone de dérive (504) reliant la surface du côté avant avec la première zone de dérive (540) ;

la troisième zone de dérive (514) reliant la première et la deuxième zone de corps (508, 580) avec la première zone de dérive (540) ; et

le degré de compensation (K(y)) qui peut être déterminé à partir de la deuxième et de la troisième zone de dérive (504, 514) étant supérieur à un et présentant un maximum dans la zone du côté de la troisième zone de dérive (514) qui est à l'opposé de la surface avant et l'équation suivante s'appliquant pour le degré de compensation K(y) :

$$K(y) = Sp(y)/Sn(y)-1$$

où y désigne la coordonnée orientée en direction de la face arrière de la puce depuis la première surface du semiconducteur et avec les règles suivantes :

$$Sn(y) = \iint ND(x,y,z)dxdz$$

$$Sp(y) = \iint NA(x,y,z)dxdz$$

et ND(x,y,z) ainsi que NA(x,y,z) désignent la concentration de donneurs ou d'accepteurs en un point P(x,y,z) à l'intérieur du composant.

2. Composant de puissance semiconducteur comprenant un contact d'anode (502) côté arrière ; une zone d'émetteur (505) côté arrière d'un premier type de conduction $p^+$, laquelle est reliée avec le contact d'anode (502) côté arrière ; une région de dérive (504, 514, 540) qui est reliée avec la zone d'émetteur (505) côté arrière et qui atteint partiellement la surface du côté avant ;

une structure de commande MOS (503, 506, 560, 508, 580, 509) côté avant, comprenant une zone de source (506) du deuxième type de conduction $n^+$ et une première zone de corps (508) du premier type de conduction p, une zone d'émetteur (560) du deuxième type de conduction $n^+$, laquelle est entourée par une deuxième zone de corps (580) du premier type de conduction p, lesquelles sont introduites dans la région de dérive (504, 514, 540), la première et la deuxième zone de corps (508, 580) étant espacées l'une de l'autre, et un contact de commande (503) disposé de manière isolée, lequel est disposé au-dessus de la première et de la deuxième zone de corps (508, 580) et au-dessus d'une partie (504, 514) se trouvant entre celles-ci de la région de dérive (504) qui atteint la surface du côté avant ; et

un contact de cathode (501) côté avant qui est relié avec la zone de source (506) et la première zone de corps (508) ; composant avec lequel

la région de dérive (504, 514, 540) présentant une première zone de dérive (540) du deuxième type de conduction $n^-$, une deuxième zone de dérive (504) du deuxième type de conduction n et une troisième zone de dérive (514) du premier type de conduction p ;

la première zone de dérive (540) étant une zone enfouie ;

la deuxième zone de dérive (504) reliant la zone de la surface qui se trouve entre la première et la deuxième zone de corps (508, 580) avec la première zone de dérive (540) ; la troisième zone de dérive (514) reliant la deuxième zone de corps (580) avec la première zone de dérive (540) ; et

le degré de compensation (K(y)) qui peut être déterminé à partir de la deuxième et de la troisième zone de dérive (504, 514) étant supérieur à un et présentant un maximum dans la zone du côté de la troisième zone de dérive (514) qui est à l'opposé de la surface avant et l'équation suivante s'appliquant pour le degré de compensation K(y) :

$$K(y) = Sp(y)/Sn(y)-1$$

où y désigne la coordonnée orientée en direction de la face arrière de la puce depuis la première surface du semiconducteur et avec les règles suivantes :

$$Sn(y) = \iint ND(x,y,z)dxdz$$
$$Sp(y) = \iint NA(x,y,z)dxdz$$

et ND(x,y,z) ainsi que NA(x,y,z) désignent la concentration de donneurs ou d'accepteurs en un point P(x,y,z) à l'intérieur du composant.

3. Composant de puissance semiconducteur selon la revendication 1 ou 2, **caractérisé en ce qu'**une région tampon (550) du deuxième type de conduction est prévue entre la première zone de dérive (540) et la zone d'émetteur (505) côté arrière.

4. Composant de puissance semiconducteur selon la revendication 1, 2 ou 3, **caractérisé en ce qu'**une région de contact (507) du premier type de conduction, laquelle s'étend partiellement sous la zone de source (506), entoure partiellement la zone de source (506).

5. Composant de puissance semiconducteur selon l'une des revendications précédentes, **caractérisé en ce que** la première zone de corps (508) et la zone de source (506) d'une part et la troisième zone de dérive (514) d'autre part s'étendent en forme de bandes et ne s'étendent pas parallèlement les unes aux autres.

6. Composant de puissance semiconducteur selon l'une des revendications précédentes, **caractérisé en ce que** la troisième zone de dérive (514) entoure une fosse (724) remplie d'un matériau isolant.

7. Procédé de fabrication d'un composant de puissance semiconducteur selon la revendication 1 ou 2, comprenant les étapes suivantes :

   a) mise à disposition d'un substrat ayant une zone côté arrière (505a) du premier type de conduction correspondant à la zone d'émetteur (505) côté arrière et une zone côté avant (540a) du deuxième type de conduction (n⁻) correspondant à la première zone de dérive (540) ;
   b) formation d'un masque (1060a) sur le côté avant du substrat ;
   c) introduction d'une première zone (1014a) du premier type de conduction au moyen du masque (1060a) ;
   d) croissance d'une zone (504a) du deuxième type de conduction sur le côté avant du substrat ;
   e) répétition facultative des étapes c) et d) ;
   f) rendu par diffusion de la ou des zones (1014a, 1014c) du premier type de conduction (p) pour former la troisième zone de dérive (514) ;
   g) établissement de la structure de commande MOS (503, 506, 560, 508, 580, 509) côté avant ; et
   h) formation du contact d'anode (502) côté arrière et du contact de cathode (501) côté avant.

8. Procédé de fabrication d'un composant de puissance semiconducteur selon la revendication 1 ou 2, comprenant les étapes suivantes :

   a') mise à disposition d'un substrat ayant une zone côté arrière (505b) du premier type de conduction correspondant à la zone d'émetteur (505) côté arrière, une zone côté avant (504b) correspondant à la deuxième zone de dérive (504) et une zone centrale (540b) du deuxième type de conduction correspondant à la première zone de dérive (540) ;
   b') formation d'une fosse (724) sur le côté avant du substrat, laquelle s'étend jusqu'à la zone centrale (540b) du deuxième type de conduction correspondant à la première zone de dérive (540) ;
   c') formation d'un masque (1001) sur le côté avant du substrat ;
   d') introduction d'une première zone (514c, d) du premier type de conduction correspondant à la troisième zone de dérive (514) dans les parois de la fosse et le fond de la fosse ;
   e') remplissage de la fosse (724) avec un matériau isolant ;
   f') établissement de la structure de commande MOS (503, 506, 560, 508, 580, 509) côté avant ; et
   g') formation du contact d'anode (502) côté arrière et du contact de cathode (501) côté avant.

9. Procédé selon la revendication 7 ou 8, **caractérisé en ce qu'**entre la zone côté arrière (505a) du premier type de conduction correspondant à la zone d'émetteur (505) côté arrière et la zone côté avant (540a) du deuxième type de conduction correspondant à la première zone de dérive (540) est prévue une zone (550a, 550b) du deuxième type de conduction correspondant à une région tampon (550).

EP 1 384 269 B1

Fig. 2

Fig. 1

17

Fig. 3

Fig. 4

EP 1 384 269 B1

VS

1060a

1061a

540a

550a

505a

**Fig. 5a**

RS

---

1014a

1014a

VS

504a

540a

550a

505a

**Fig. 5b**

RS

---

1060c

VS

1061c

1014a

504a

1014a

540a

550a

505a

**Fig. 5c**

RS

Fig. 5d

Fig. 5e

VS

504b

540b

550b

505b

## Fig. 6a

RS

VS

1101

504b    724    504b

540b

550b

505b

## Fig. 6b

RS

VS

1102

1101

504b

724

504b

540b

550b

505b

## Fig. 6c

RS

VS

1103 ⟋ ⟍ 1101

514b

504b    504b

⟍ 724

540b

550b

505b

## Fig. 6d

RS

VS

514

504    504

724

540

550

505

## Fig. 6e

RS

Fig. 8

Fig. 7

Fig. 9

Fig. 10

EP 1 384 269 B1

Fig. 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19816448 C1
- DE 19840032 C1

- DE 19604043 A1

**In der Beschreibung aufgeführte Nicht-Patentliteratur**

- **B.J. BALIGA.** Power Semiconductor Devices. PWS Publishing Company, 1995, 543-568